# FASCICULE DE BREVET EUROPEEN

(11) **EP 0 779 775 B1**
(45) Date de publication et mention de la délivrance du brevet: **28.04.1999**
(21) Numéro de dépôt: 96402679.3
(22) Date de dépôt: 10.12.1996
(51) Int. Cl.: H05K 7/20, H05K 1/02

(54) **Assemblage électronique à drain thermique, notamment pour transformateur haute tension de lampe à décharge de projecteur de véhicule automobile**
Elektronische Baugruppe mit Wärmeabführung, besonders für Hochspannungsumwandler einer Entladungslampe von Scheinwerfer
Electronic assembly with heat transfer, particularly for high voltage transformer of a discharge head lamp of a vehicle

(30) Priorité: 11.12.1995 FR 9514647
(43) Date de publication de la demande: 18.06.1997
(73) Titulaire: VALEO ELECTRONIQUE, 94000 Creteil (FR)
(72) Inventeur: Herzberger, Erick, 93220 Cagny (FR); Wacheux, Patrick, 94800 Villejuif (FR); Nicolai, Jean-Marc, 92400 Courbevoie (FR); Cassese, Bruno, 94000 Creteil (FR)
(74) Mandataire: Le Forestier, Eric

(56) Documents cités:
- DE-A- 2 919 058
- DE-A- 3 932 213
- DE-A- 4 134 101
- DE-C- 4 240 996
- US-A- 4 974 119

## Description

La présente invention est relative à un assemblage électronique à drain thermique, notamment pour un transformateur haute tension de lampe à décharge de véhicule automobile.

On connaît déjà des structures d'assemblage électronique à drain thermique. On pourra à cet égard se référer à DE 42 40 996 et DE 39 32 213.

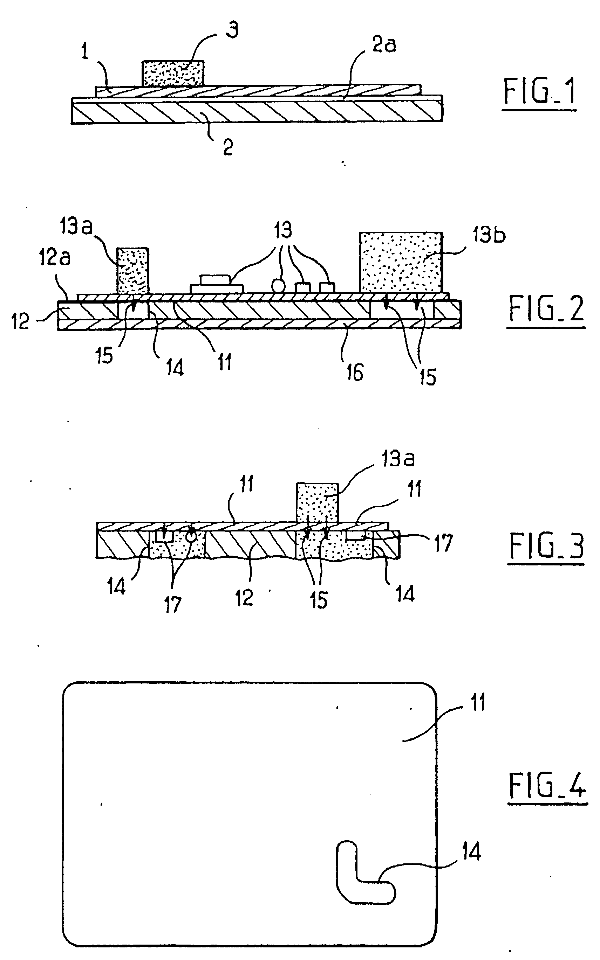

Une structure d'assemblage électronique à drain thermique d'un type connu de l'art antérieur a été illustrée sur la figure 1.

Elle comporte une carte 1 à circuits imprimés, dont le substrat est par exemple en un matériau époxy renforcé par des fibres de verre et qui présente des pistes électriquement conductrices sur chacune de ses faces.

Cette carte 1 double face est assemblée sur un drain thermique 2 par pressage à chaud. Lors de l'opération de pressage à chaud, les pistes de la face de la carte 1 directement en regard du drain 2 se soudent par fusion sur ledit drain 2.

Celui-ci est par exemple une semelle en aluminium recouverte d'une couche 2a d'isolant électrique qui assure l'isolation électrique des pistes conductrices vis à vis de ladite semelle après le pressage à chaud.

Des composants 3 de type CMS (composants à montage de surface) sont soudés à la vague sur l'autre face de la carte 1.

Une telle structure d'assemblage ne permet pas d'utiliser des composants qui sont de type traversant, ce qui est généralement le cas des transformateurs haute tension pour l'alimentation de lampe à décharge.

Un tel transformateur comporte en effet classiquement quatre à six pattes traversantes, qui servent à son maintien mécanique sur la carte du circuit imprimé et dont les extrémités sont soudées sur la face de ladite carte qui est opposée au côté de ladite carte où le transformateur s'étend.

Cette structure d'assemblage impose par conséquent d'utiliser à la place de composants de type traversant des composants CMS spécifiques, qui notamment dans le cas des transformateurs haute tension, sont plus onéreux que des composants traversants classiques.

Un but de l'invention est de proposer une structure d'assemblage qui permet de pallier cet inconvénient.

Par ailleurs, la structure d'assemblage qui vient d'être décrite en référence à la figure 1, empêche d'exploiter l'ensemble des possibilités offertes par la nature double face des cartes 1, puisque seule l'une des faces de ces cartes 1 peut recevoir des composants CMS.

Un autre but de l'invention est donc de proposer une structure d'assemblage électronique à drain thermique qui permet à chacune des faces de la carte à circuit imprimé de recevoir des composants CMS.

Plus particulièrement, l'invention, telle que revendiquée, propose un assemblage électronique comportant un drain thermique, ainsi qu'une carte à circuits imprimés double face assemblée par pressage à chaud sur ledit drain thermique, ladite carte portant sur sa face opposée audit drain thermique une pluralité de composants à montage de surface, ladite carte portant également au moins un composant traversant, le drain thermique présentant un évidement au droit de la zone de la carte à circuits imprimés qui reçoit ce composant traversant, les extrémités des pattes dudit composant étant soudées sur ladite carte à l'intérieur dudit évidement.

L'invention, telle que revendiquée, propose également un procédé pour la réalisation d'un tel assemblage.

D'autres caractéristiques et avantages de l'invention ressortiront encore de la description qui suit. Cette description est purement illustrative et non limitative. Elle doit être lue en regard des dessins annexés sur lesquels :
- la figure 1, déjà discutée, est une vue en coupe d'une structure de montage de l'art antérieur ;
- les figures 2 et 3 sont des vues en coupe illustrant deux modes de réalisation possibles pour la structure de montage proposée par l'invention ;
- la figure 4 est une vue de dessus illustrant un exemple de géométrie possible pour les évidements du drain thermique.

L'assemblage illustré sur la figure 2 comporte une carte 11 à circuits imprimés double face assemblée par pressage à chaud sur un drain thermique 12, ainsi que des composants CMS 13 et traversants 13a, 13b rapportés sur la face de cette carte 11 opposée au drain 12.

La carte 11 et le drain thermique 12 sont similaires à la carte 1 et au drain 2 de l'assemblage décrit en référence à la figure 1. En particulier, le drain thermique 12 est un substrat métallique, par exemple en aluminium, recouvert d'une couche 12a d'isolant électrique.

Le drain 12 diffère du drain 2 en ce que son substrat présente une pluralité d'évidements 14 situés au droit des zones de la carte 11 destinées à recevoir les composants traversants 13a et 13b.

Les extrémités des pattes 15 de ces composants 13a, 13b sont soudées à l'intérieur des évidements 14 sur la face de la carte à circuit imprimé 11 qui est en contact avec le drain thermique 12.

Une plaque métallique 16 est rapportée sur la face du drain thermique 12 qui est opposée à la carte 11. Cette plaque 16 assure l'étanchéité de l'assemblage. De façon à présenter un bon couplage thermique avec le drain 12, sa face en contact avec ledit drain 12 présente une grande qualité de surface.

La réalisation d'une telle structure s'effectue de la façon suivante.

Les évidements 14 sont par exemple réalisés par usinage à travers le substrat métallique du drain 12.

La carte 11 à circuits imprimés est ensuite rapportée sur le drain 12 et fixée sur celui-ci par pressage à chaud.

Puis, les composants CMS 13 sont fixés par une soudure à la vague sur le circuit imprimé de la carte 11, qui est du côté opposé au drain 12.

Une fois cette opération terminée, les composants traversants 13a, 13b sont fixés sur la carte 11 par soudure à l'arc ou au fer à souder des extrémités de leurs pattes 15 sur les portions de circuit imprimé que présente la carte 11 en regard des évidements 14.

Le cas échéant, on soude ensuite à la vague ou en refusion d'autres composants CMS sur la face de la carte 11 sur laquelle sont soudées les pattes 15.

C'est ce qui a été illustré sur la figure 3 sur laquelle on a représenté une variante de réalisation dans laquelle des composants CMS 17 sont soudés à l'intérieur des évidements 14 sur la carte 11, à côté des extrémités des pattes 15.

Bien entendu, cela suppose que les évidements 14 sont assez larges pour pouvoir recevoir de tels composants CMS et pour permettre le cas échéant la soudure à la vague.

Dans cette variante, en outre, l'étanchéité de l'assemblage y est assurée non pas par une plaque métallique rapportée sur le drain 12, mais par une résine d'isolation 18 coulée dans les évidements 14.

Un exemple de géométrie d'évidement a été illustré sur la figure 4.

L'évidement 14 représenté sur cette figure a une forme en L, qui correspond à une disposition particulière de pattes d'un transformateur haute tension.

Bien entendu, cette géométrie varie selon la disposition des pattes du composant traversant.

Elle est choisie de façon à minimiser la surface occupée par les évidements 14 sur le drain 12 et à maximiser la surface du drain 12 qui sert au rayonnement des calories. Ce choix permet également de limiter le volume de résine d'isolation nécessaire pour remplir les évidements 14. Cette résine est en effet coûteuse.

## Revendications

1. Assemblage électronique comportant un drain thermique, ainsi qu'une carte à circuits imprimés double face assemblée par pressage à chaud sur ledit drain thermique (12), ladite carte (11) portant sur sa face opposée audit drain thermique (12) une pluralité de composants (13) à montage de surface, ladite carte (11) portant également au moins un composant traversant (13a, 13b), le drain thermique (12) présentant un évidement (14) au droit de la zone de la carte (11) à circuits imprimés qui reçoit ce composant traversant (13a, 13b), les extrémités des pattes dudit composant étant soudées sur ladite carte (11) à l'intérieur dudit évidement (14).

2. Assemblage électronique selon la revendication 1, caractérisé en ce que la carte (11) à circuits imprimés porte à l'intérieur de l'évidement (14) au moins un composant (17) à montage de surface.

3. Assemblage électronique selon la revendication 1, caractérisé en ce que l'évidement (14) du drain est rempli d'une résine d'isolation (18).

4. Assemblage électronique selon l'une des revendications 1 ou 2, caractérisé en ce qu'une plaque d'étanchéité métallique (16) est rapportée sur la face du drain traversant opposée à la carte (11) à circuits imprimés.

5. Assemblage électronique selon l'une des revendications précédentes, caractérisé en ce que le composant traversant est un transformateur haute tension, notamment de lampe à décharge de véhicule automobile.

6. Procédé de réalisation d'un assemblage électronique selon l'une des revendications précédentes, le procédé comprenant les différentes étapes suivantes :
- on presse à chaud une carte (11) à circuits imprimés double face sur un drain thermique (12) présentant au moins un évidement (14),
- on soude à la vague ou par refusion sur la face de ladite carte (11) qui est opposée au drain des composants à montage de surface,
- on soude à l'arc ou au fer à souder sur la carte (11), à l'intérieur de l'évidement (14), les pattes d'un composant traversant.

7. Procédé selon la revendication 6, caractérisé en ce qu'on soude à la vague à l'intérieur de l'évidement (14) au moins un autre composant (17) à montage de surface.

8. Procédé selon l'une des revendications 6 ou 7, caractérisé en ce qu'on remplit ensuite l'évidement (14) d'une résine d'isolation.

9. Procédé selon l'une des revendications 6 ou 7, caractérisé en ce qu'on rapporte sur la face du drain traversant opposée à la carte (11) à circuits imprimés une plaque d'étanchéité métallique (16) .

## Patentansprüche

1. Elektronische Baugruppe, umfassend eine Wärmeabführung sowie eine doppelseitig bedruckte Leiterplatte, die durch Heißpressen auf der besagten Wärmeabführung (12) angebracht ist, wobei die besagte Leiterplatte (11) auf ihrer der besagten Wärmeabführung (12) gegenüberliegenden Seite eine Mehrzahl von oberflächenmontierten Bauelementen (13) trägt, wobei die besagte Leiterplatte (11) außerdem mindestens ein durchgehendes Bauelement (13a, 13b) trägt, wobei die Wärmeabführung (12) eine Aussparung (14) in Höhe des Bereichs der Leiterplatte (11) aufweist, der dieses durchgehende Bauelement (13a, 13b) aufnimmt, und wobei die Enden der Ansätze des besagten Bauelements auf der besagten Leiterplatte (11) im Innern der besagten Aussparung (14) verlötet sind.

2. Elektronische Baugruppe nach Anspruch 1 , **dadurch gekennzeichnet**, daß die Leiterplatte (11) im Innern der Aussparung (14) mindestens ein oberflächenmontiertes Bauelement (17) trägt.

3. Elektronische Baugruppe nach Anspruch 1 , **dadurch gekennzeichnet,** daß die Aussparung (14) der Wärmeabführung mit einem Isolierharz verfüllt ist.

4. Elektronische Baugruppe nach einem der Ansprüche 1 oder 2 , **dadurch gekennzeichnet,** daß eine metallische Dichtungsplatte (16) auf der der Leiterplatte (11) gegenüberliegenden Seite der durchgehenden Wasserabführung angebracht ist.

5. Elektronische Baugruppe nach einem der vorangehenden Ansprüche, **dadurch gekennzeichnet,** daß das durchgehende Bauelement ein Hochspannungsumwandler, insbesondere einer Entladungslampe für ein Kraftfahrzeug ist.

6. Verfahren zur Ausführung einer elektronischen Baugruppe nach einem der vorangehenden Ansprüche, wobei das Verfahren die folgenden verschiedenen Schritte umfaßt:
- eine doppelseitig bedruckte Leiterplatte (11) wird heiß auf einer Wärmeabführung (12) aufgepreßt, die mindestens eine Aussparung (14) aufweist,
- auf der Seite der besagten Leiterplatte (11), die der Wärmeabführung gegenüberliegt, werden mittels Schwall- oder Aufschmelzlöten oberflächenmontierte Bauelemente verlötet,
- auf der Leiterplatte (11), im Innern der Aussparung (14), werden mittels Lichtbogen oder Lötkolben die Ansätze eines durchgehenden Bauelements verlötet.

7. Verfahren nach Anspruch 6 , **dadurch gekennzeichnet,** daß im Innern der Aussparung (14) mittels Schwall-Löten mindestens ein anderes oberflächenmontiertes Bauelement (17) verlötet wird.

8. Verfahren nach einem der Ansprüche 6 oder 7,**dadurch gekennzeichnet,** daß die Aussparung (14) anschließend mit einem Isolierharz verfüllt wird.

9. Verfahren nach einem der Ansprüche 6 oder 7, **dadurch gekennzeichnet,** daß auf der der Leiterplatte (11) gegenüberliegenden Seite der durchgehenden Wärmeabführung eine metallische Dichtungsplatte (16) angebracht wird.

## Claims

1. An electronic assembly comprising a heat sink and a double-sided printed circuit card assembled to said heat sink (12) by hot pressing, said card (11) carrying a plurality of surface-mounting components (13) on its face remote from said heat sink (12). said card (11) also carrying at least one through component (13a, 13b). the heat sink (12) having a void (14) over the zone of the printed circuit card (11) that receives the through component (13a, 13b), the ends of the pins of said component being bonded to said card (11) inside said void (14).

2. An electronic assembly according to claim 1, characterized in that the printed circuit card (11) carries at least one surface-mounting component (17) inside the void (14).

3. An electronic assembly according to claim 1, characterized in that the void (14) of the heat sink is filled with an insulating resin (18).

4. An electronic assembly according to claim 1 or 2, characterized in that a metal sealing plate (16) is applied to the face of the heat sink remote from the printed circuit card (11).

5. An electronic assembly according to any preceding claim. characterized in that the through component is a high density transformer, in particular for a motor vehicle discharge lamp.

6. A method of making an electronic assembly according to any preceding claim. the method comprising the following various steps:
• the double-sided printed circuit card (11) is hot-pressed to a heat sink (12) having at least one void (14);
• surface-mounting components are bonded to the face of said card (11) remote from the heat sink by flow soldering or by reflow soldering; and
• the pins of a through component are bonded to the card (11) inside the void (14) by arc welding or by a soldering iron.

7. A method according to claim 6, characterized in that at least one other surface-mounting component (17) is flow soldered inside the void (14).

8. A method according to claim 6 or 7, characterized in that the void (14) is subsequently filled with an insulating resin.

9. A method according to claim 6 or 7, characterized in that a metal sealing plate (16) is applied to the face of the heat sink remote from the card (11).
